# EUROPEAN PATENT APPLICATION

(11) **EP 0 752 657 A2**
(43) Date of publication of application: **08.01.1997**
(21) Application number: 96304728.7
(22) Date of filing: 26.06.1996
(51) Int. Cl.: G06F 11/267, G01R 31/28

(54) **Test mode access control circuit**

(30) Priority: 03.07.1995 US 497783
(71) Applicant: FORD MOTOR COMPANY LIMITED, Brentwood Essex (GB); FORD FRANCE S. A., 92506 Rueil-Malmaison Cédex (FR); FORD-WERKE AKTIENGESELLSCHAFT, 50735 Köln (DE)
(72) Inventor: Lane, Murray, Colorado Springs, Colorado 80917 (US); Callahan, Kent, Colorado Springs, Colorado 80920 (US)
(74) Representative: Messulam, Alec Moses

(57) **Abstract**

An apparatus is described for controlling access to a test mode in an integrated circuit (100) having first and second external crystal connections (28,26) includes a clocking circuit (18,20) and a converting circuit (12,14,16). The clocking circuit utilises signals applied to the first and second external crystal connections (28,26) to generate a clock signal (30) for the integrated circuit (100) and a hardware reset signal (34) for forcing the test mode hardware to a predetermined state. The converting circuit (12,14,16) generates a test mode enable signal from the clock signal (32) and the hardware reset signal which permits the integrated circuit to access the test mode.

## Description

The present invention relates to testing of integrated circuits, and, more particularly, to a circuit for enabling an integrated circuit to be placed into a testing mode.

Historically, electronic components have often been tested before being installed onto a printed circuit board to verify proper operation. While testing of discrete components was readily accomplished with relatively unsophisticated tools, the advent of the packaged integrated circuit gave rise to new frontiers in testing. Integrated circuits were generally more complex than discrete electronic components, yet their packaging rendered them less accessible for non-destructive testing. In general, manufacturers had only the exposed input and output pins with which to work, limiting their testing options.

Over time, technological advancements in integrated circuit layout and manufacture gave rise to highly complex integrated circuits capable of performing sequential operations. In order to step through these operations, a timing signal of a relatively constant frequency, known as a clock, was required. The clock signal was often provided by an external vibrating quartz crystal, a ceramic resonator, or some other device whose frequency could be predicted and specified.

The complexity and flexibility of these circuits led circuit designers to include test circuits for testing the functional circuitry as part of the integrated circuit. This circuitry could be activated by forcing the integrated circuit into a special "test" mode, during which it would forego regular operation and selectively execute tests to verify that particular circuit features were operating properly. To enable the integrated circuit to differentiate between test mode and regular operation, designers devised assorted ways of accessing the test mode, including special input and output pins dedicated exclusively to this purpose. The integrated circuit would look for signals on these dedicated pins at predetermined time intervals. If it found them, it would enter test mode, instead of operating its regular functions.

While this method of accessing the test mode was satisfactory, it reduced the number of pins available for regular integrated circuit operation. Some integrated circuits with serial or parallel communications capability avoided this by using locking devices with passwords, but these could be slow, cumbersome to access, and susceptible to noise. It would thus be desirable to have a test mode access circuit which overcomes the aforementioned difficulties.

An apparatus for controlling access to a test mode in an integrated circuit having first and second external crystal connections includes a clocking circuit and a converting circuit. The clocking circuit utilises signals applied to the first and second external crystal connections to generate a clock signal for the integrated circuit and a hardware reset signal for forcing the test mode hardware to a predetermined state. The converting circuit generates a test mode enable signal from the clock signal and the hardware reset signal which permits the integrated circuit to access the test mode.

The present invention provides a new and improved apparatus for accessing the test mode in an integrated circuit having two or more external crystal connections. More specifically, it utilises only the integrated circuit's existing external crystal connections to force the integrated circuit into test mode.

A primary advantage of this invention is that it eliminates the need to dedicate pins for accessing the test mode of an integrated circuit. An additional advantage is that the invention can be used with a wide variety of integrated circuits, including those without serial or parallel communications capability. A further advantage is that access to test mode operation is both simple and secure.

The invention will now be described further, by way of example, with reference to the accompanying drawings, in which:
Figure 1 is a block diagram of an integrated circuit with a test mode access control circuit according to the present invention,,
Figure 2 shows a preferred embodiment of a test mode access circuit according to the present invention,
Figure 3 shows signals associated with a test mode access circuit operating under non-test conditions-
Figure 4 shows signals associated with a test mode access circuit which is entering test mode.

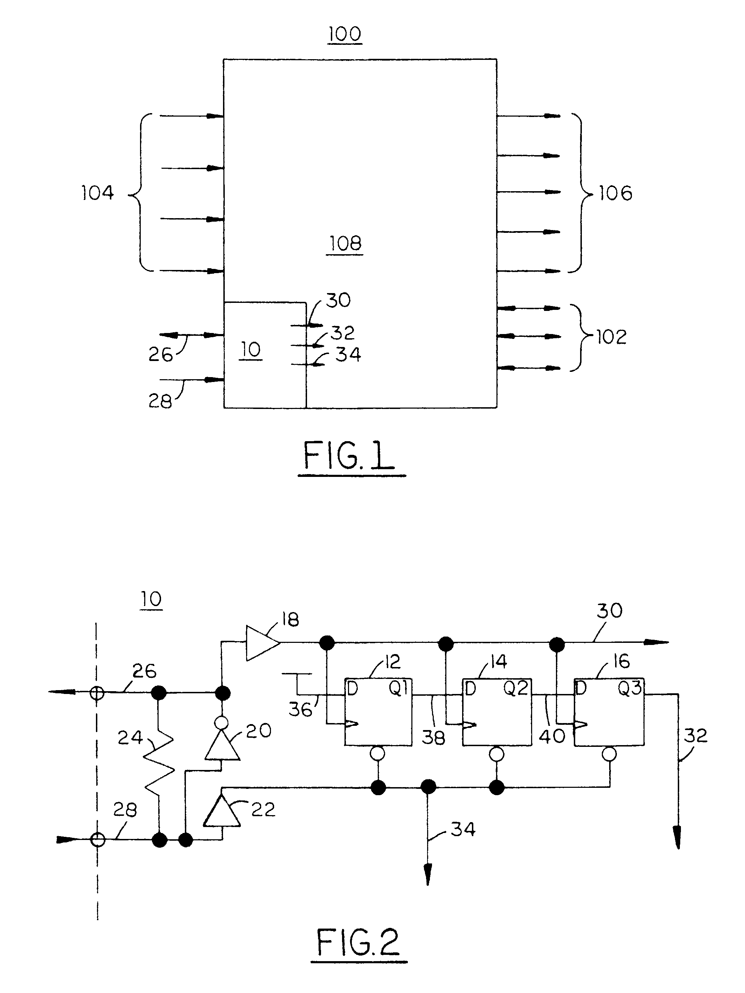

Referring now to Figure 1, an integrated circuit 100 includes a test mode access circuit 10 and other multipurpose circuitry designated generally 108. Integrated circuit 100 interfaces with other components via inputs 104, outputs 106, and bi-directional connections 102. Integrated circuit 100 also has an external crystal input 28, known as a first external crystal connection, and an external crystal bi-directional connection 26, known as a second external crystal connection, both of which might be attached to a quartz crystal or ceramic resonator (not shown) under regular operation. Note that while integrated circuit 100 may include a microprocessor, it need not have such capability for the purposes of the present invention. In general, all that is necessary is that integrated circuit have first and second external crystal connections 28, 26.

Test mode access circuit 10 converts signals received through the external crystal connections 26, 28 into a clock signal 30, also known as a clock, which can be used by multipurpose circuitry 108 for both regular- and testing operations. Test mode access circuit 10 similarly converts signals from external crystal connections 26, 28 into a test mode enable signal 32 and a test mode reset signal 34. Test mode enable signal 32 can be used to communicate to multipurpose circuitry 108 that testing operation is desired. Test mode reset signal 34 can be used to force multipurpose circuitry 108 and test mode circuitry 10 to a known predetermined state so that test results may be analysed and interpreted based on known conditions.

Turning now to Figure 2, a preferred embodiment of a test mode access circuit according to the present invention 10 includes a resistor 24 connected between two external crystal connections 26, 28. Resistor 24 is typically used to establish a DC bias for the signal generated by the attached crystal (not shown). For example, one application of the present invention utilises a 16.104 megahertz quartz crystal attached to a 300 KΩ resistor.

Buffer 22 takes its input from first external crystal connection 28 and replicates this input at its output. Buffer 22 is used to isolate test mode reset signal 34 from outside signals which might otherwise trigger a false reset condition. Similarly, buffer 18 takes its input from second external crystal connection 26 and replicates this input at its output, which is the clock signal 30. Since clock signal 30 may be used as an input by multiple circuits within multipurpose circuitry 108, buffer 18 is used to increase the drive capability of the signal. Buffers 18, 22 are standard buffer circuits, such as, for example, CD4050.

Inverter 20 has an input electrically connected to first external crystal connection 28 and has an output electrically connected to both the input of buffer 18 and second external crystal connection 26. Inverter 20 typically inverts any signal received on its input and sends this as its output. However, inverter 20 is a weak inverter with a relatively high source impedance of, for example, 200 ohm, so that its output may also be overridden by a signal provided through the second external crystal connection 26. This feature is used to activate the test mode operation. For example, inverter 20 could be a CD4049 inverter.

Three flip-flop circuits 12, 14, 16 are used to generate the test mode enable signal 32. While a preferred embodiment utilises D-type flip-flops with reset inputs responsive to a digital logic level zero, other types of flip-flops could also be utilised. For example, CD40174 flip-flop circuits could be selected. Additionally, either Q or Q' flip-flop outputs could be used to supply the requisite signals. This choice is best determined by the logic level requirements of the circuit to be driven and does not affect performance. Also, less or more than three flip-flops could be used to generate the desired signals. A preferred embodiment utilises three flip-flop circuits to provide additional layers of security against any timing conditions which might otherwise create a false signal.

First flip-flop circuit 12 has a Ql output 38, a D input 36 tied to a voltage representative of a digital logic level one and a clock input driven by clock signal 30. First flip-flop circuit 12 is reset by a voltage representative of a digital logic level zero on the test mode reset signal 34, sending it to a known state where its Ql output 38 will be a digital logic level zero. Second flip-flop circuit 14 has a Q2 output 40, a D input tied to the Ql output 38 of first flip-flop circuit 12, and a clock input driven by clock signal 30. Second flip-flop circuit 14 is reset by a voltage representative of a digital logic level zero on the test mode reset signal 34, sending it to a known state where its Q2 output 40 will be a digital logic level zero. Third flip-flop circuit 16 has a Q3 output 32, a D input tied to the Q2 output 40 of second flip-flop circuit 14, and a clock input driven by clock signal 30. Third flip-flop circuit 16 is reset by a voltage representative of a digital logic level zero on the test mode reset signal 34, sending it to a known state where its Q3 output 32 will be a digital logic level zero. Q3 output 32 of third flip-flop circuit 16 provides test mode enable signal 32.

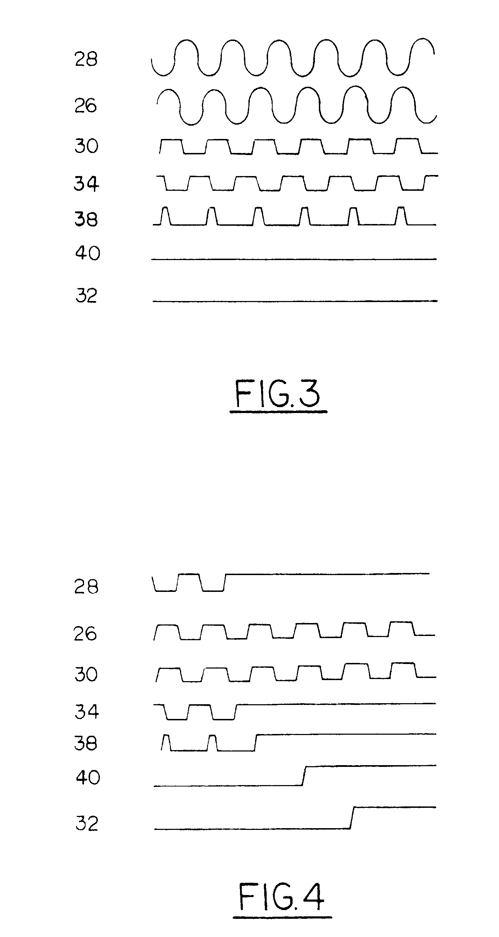

Figure 3 shows signals associated with a preferred embodiment of a test mode access circuit operating under non-test conditions, with time progressing from left to right. First and second external crystal connections 28, 26 are attached to a quartz crystal. When power is applied, the crystal vibrates, producing a signal at each of the first and second external crystal connections 28, 26 as shown in Figure 3. Buffers 22, 18 and weak inverter 20 convert these signals into a slightly delayed digital signal of like frequency, which is supplied as clock signal 30 to multipurpose circuitry 108.

Buffer 22 converts the wave form from first external crystal connection 28 into a test mode reset signal 34 which periodically resets flip-flop circuits 12, 14, 16, as well as any additional test circuitry attached to signal 34. While the output Ql 38 of first flip-flop circuit 12 may pulse to a digital logic level one in between resets, this pulse is not recognised by second flip-flop circuit 14 prior to reset. Hence outputs Q2 40 and Q3 32 of second and third flip-flop circuits 14, 16 remain at digital logic level zero, so test mode enable signal 32 remains inactive.

Figure 4 shows signals associated with a preferred embodiment of a test mode access circuit which is entering test mode, with time progressing from left to right. First and second external crystal connections 28, 26 are attached to test equipment (not shown). Test equipment provides signals to both first and second crystal connections 28, 26 as shown in Figure 4. Pulses are provided at first external crystal connection 28 to reset the test circuitry by driving the test mode reset signal 34 to its active low state. Similarly, pulses are provided at second external crystal 26, overriding the output from weak inverter 20 and providing a slightly delayed digital signal of like frequency, which is supplied as the clock signal 30 to multipurpose circuitry 108.

Next, a digital logic level one is supplied to first external crystal connection 28. This deactivates test mode reset signal 34, permitting flip-flops 12, 14, 16 to take their respective Q outputs from their respective D inputs when clocked by clock signal 30. The Ql output 38 of first flip-flop circuit 12 rises to a digital logic level one, which is recognised and reflected in the Q2 output 40 of second flip-flop circuit 14 on the next active edge of clock signal 30. Subsequently, third flip-flop circuit 16 also recognises and reflects this in Q3 output 32, which is used as test mode enable signal 32. This signal is sent to multipurpose circuitry 108, where it may be used to activate various integrated circuit operations peculiar to test mode

## Claims

1. A control circuit for providing access to a test mode in an integrated circuit (100) having first and second external crystal connections (28,26) comprising:
clocking means (18,20) for converting a plurality of signals received through the first and second external crystal connections (26,28) into a periodic clock signal (30) for sequencing the integrated circuit (100) and a test mode reset signal (34) for forcing the integrated circuit to assume a predetermined state; and
converting means (12,14,16) drive by said clocking means, for converting the clock signal (30) and the test mode reset signal (34) into a test mode enable signal (32) representative of the integrated circuit being permitted to enter the test mode.

2. A circuit according to Claim 1, said clocking means further comprising an inverter having a high source impedance, said inverter having an output electrically connected to the second external crystal connection.

3. A circuit according to Claim 1 or 2, said converting means further comprising a first flip-flop circuit having a clock input electrically connected to the clock signal, a reset input electrically connected to the test mode reset signal, a data input electrically connected to a voltage representative of a digital logic level one, and an output.

4. A circuit according to Claim 3, said converting means further comprising a second flip-flop circuit having a clock input electrically connected to the clock signal, a reset input electrically connected to the test mode reset signal, a data input electrically connected to said first flip-flop circuit output, and an output.

5. A circuit according to Claim 1, said converting means comprising first, second, and third flip-flop circuits, each of said flip-flop circuits having a clock input electrically connected to the clock signal, a reset input electrically connected to the test mode reset signal, a data input, and an output, the data input of said first flip-flop circuit being electrically connected to a voltage representative of a digital logic level one, the data input of said second flip-flop circuit being electrically connected to the output of said first flip-flop circuit, and the data input of said third flip-flop circuit being electrically connected to the output of said second flip-flop circuit.

6. A control circuit for providing access to a test mode in an integrated circuit having first and second external crystal connections, comprising:
a resistor electrically connected to the first and second external crystal connections;
a first buffer having an input electrically connected to the first external crystal connection and having an output;
an inverter having a high source impedance, said inverter having an input electrically connected to the first external crystal connection and an output electrically connected to the second external crystal connection;
a second buffer having an input electrically connected to said inverter output and having an output; a first flip-flop circuit having a data input electrically connected to a voltage representative of a digital logic level one and having an output;
a second flip-flop circuit having a data input electrically connected to the output of said first flip-flop circuit and having an output; and
a third flip-flop circuit having a data input electrically connected to the output of said second flip-flop circuit and having an output,
each of said first, second, and third flip-flop circuits having a clock input electrically connected to the output of said second buffer and a reset input electrically connected to the output of said first buffer.

7. A method for actuating a test mode in an integrated circuit having first and second external crystal connections, comprising the steps of:
applying a reset signal to the first external crystal connection to force the integrated circuit to a predetermined reset state;
applying a periodic signal to the second external crystal connection to provide a periodic clock signal to the integrated circuit; and
replacing said reset signal with an enabling signal to permit the integrated circuit to enter the test mode.
